# EUROPEAN PATENT SPECIFICATION

(11) **EP 1 367 597 B1**
(45) Date of publication and mention of the grant of the patent: **03.08.2005**
(21) Application number: 02425360.1
(22) Date of filing: 31.05.2002
(51) Int. Cl.: G11C 29/00

(54) **Test structure for the measurement of contact to gate distance in non-volatile memory devices and corresponding test method**
Teststruktur zur Messung des Kontakt-Gate-Abstandes in nichtflüchtigen Speichern und zugehöriges Testverfahren
Structure de test pour la mesure de la distance contact-grille dans des mémoires non-volatiles et procédé correspondant

(43) Date of publication of application: 03.12.2003
(73) Proprietor: STMicroelectronics S.r.l., 20041 Agrate Brianza (Milano) (IT)
(72) Inventor: Camerlenghi, Emilio, 24129 Bergamo (IT); Cappelletti, Paolo, 20030 Seveso (Milano) (IT); Ghilardi, Tecla, 24060 S. Paolo d'Argon (Bergamo) (IT); Sali, Mauro, 26866 S. Agelo Lodigiano (Lodi) (IT); Servalli, Giorgio, 24040 Ciserano (Bergamo) (IT)
(74) Representative: Botti, Mario

(56) References cited:
- US-A- 5 712 816
- US-B1- 6 331 954

## Description

### Field of the Invention

The present invention relates to a FLASH memory device having an improved structure.

More specifically, the invention relates to an integrated non-volatile memory device including a matrix of cells organised into rows and columns and including corresponding row and column decoding circuits as well as read, modify and erase circuits for reading and modifying data stored in the memory cells.

The invention further relates to a test method for measuring a contact to gate distance in a non-volatile memory device.

The invention relates to semiconductor non-volatile FLASH memory devices which are electrically programmable and erasable and manufactured by CMOS technology; the following description is made with reference to this specific field of application just for convenience of explanation.

### Known Art

According to the prior art, in the current manufacturing technology of the FLASH memory devices the cell "channel" erasing technique is becoming more and more used.

As is known to the skilled in this art, this erasing mechanism involves the application of a large bias (14-18V) between the gates and the substrate of the cells for a period of time of about 100-500 ms/cycle. The same potential difference is applied also between the word lines of the Flash memory device and the drain/source contacts.

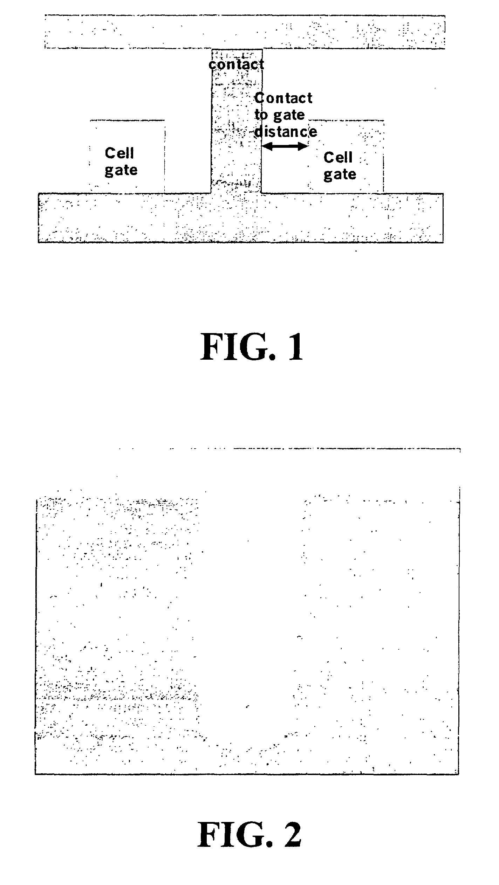

However, in the meantime, the contact to gate distance, as shown in Figure 1, is becoming smaller and smaller as the technology shrinks (for 0.13 um technology this distance is below 90 nm).

These two items show that the quality of the dielectric and the control of the effective contact to gate distance are key points for the reliability and the real possibility to reduce the size of the FLASH cells.

Its clear that these kinds of variable items, become more and more critical during device life time, if not screened in line or during device test, since the erasing bias increases after cycling because of cell performances degradation. This variability can even cause the breakdown of the dielectric layer between contacts and gates, as shown in the picture example of Figure 2.

At present the contact to gate distance is monitored in line through overlay measurements between contact mask and word line mask on a few sites of few wafers of each lot.

For instance a solution of this kind is disclosed in the US patent No. 5,712,816 assigned to the same Applicant.

The limitations of this approach are:
- Low statistics for in-line measurements and high cost of overlay measurement;
- The in-line measurement is not fully realistic, since contact to gate distance depends also on contact and word line shape/dimension.

Moreover, even if this kind of event is always localised in single defective cells, its failure rate depends largely on the intrinsic thickness of the involved dielectric that is on the distance between contact and gate.

The technical problem that the present invention would like to solve is that of preventing a possible break of the memory device under an erasing phase.

### Summary of the invention

The solution idea behind the present invention is that of providing an improved memory device including a test structure for the measurement of the effective distance between the contact and the gate of the memory cells. As above mentioned, this distance is extremely important for device reliability.

The improved structure includes a second matrix of memory cells, having as a whole a smaller size, and wherein contacts are gradually misaligned toward the wordlines.

This test structure allows monitoring the critical parameters on every single device during its electrical test (EWS) and to classify or reject each device according to the measured contact to gate distance.

According to this solution idea, the technical problem is solved by an integrated non-volatile memory device including a test structure defined in the annexed claim 1.

Consequently, it has been introduced on the memory devices an electrical test of intrinsic contact to gate distance, which depends on contacts misalignment and on contacts/gates dimension control.

The invention also relates to a test method as defined in the annexed claim 11.

The features and advantages of the test structure and method according to the invention can be more clearly understood by reading the following description of an embodiment thereof, given by way of non-limiting example with reference to the accompanying drawings.

### Brief description of the drawings

- Figure 1 is a schematic view of at least a memory cell of a memory device and a contact close to the gate region of the cell; the contact to gate distance is indicated too;
- Figure 2 is a picture showing a real failure situation due to the short distance between the contact and the gate region of a memory cell;
- Figure 3 is a schematic top view of an improved memory device according to the principle of the present invention;
- Figure 4 is a schematic and enlarged view of a portion of the memory device of figure 3;
- Figure 5 is a schematic view of an integrated memory device including a memory portion according to Figure 3.

### Detailed description

The test structures according to the present invention and a corresponding dedicated testing method are described in the following paragraphs.

However, the process steps and the structures described herein below do not form a complete process flow for manufacturing integrated circuits. In fact, this invention can be put in practice jointly with integrated circuit manufacturing techniques currently used in the art, and only those common process steps will be discussed herein as are necessary to an understanding of the invention.

The drawing figures which show cross-sections through a semiconductor wafer are not drawn to scale but rather to highlight major features of the invention.

The following detailed description deals with non-volatile FLASH memory devices for illustration purposes, it being understood that the expounded considerations equally apply to other memory devices such as the EPROM or the EEPROM type.

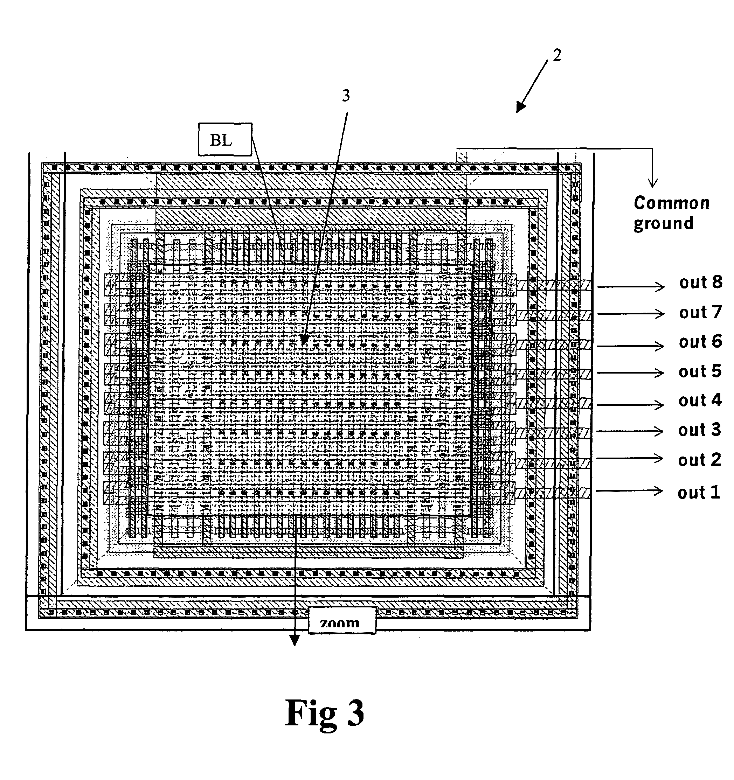

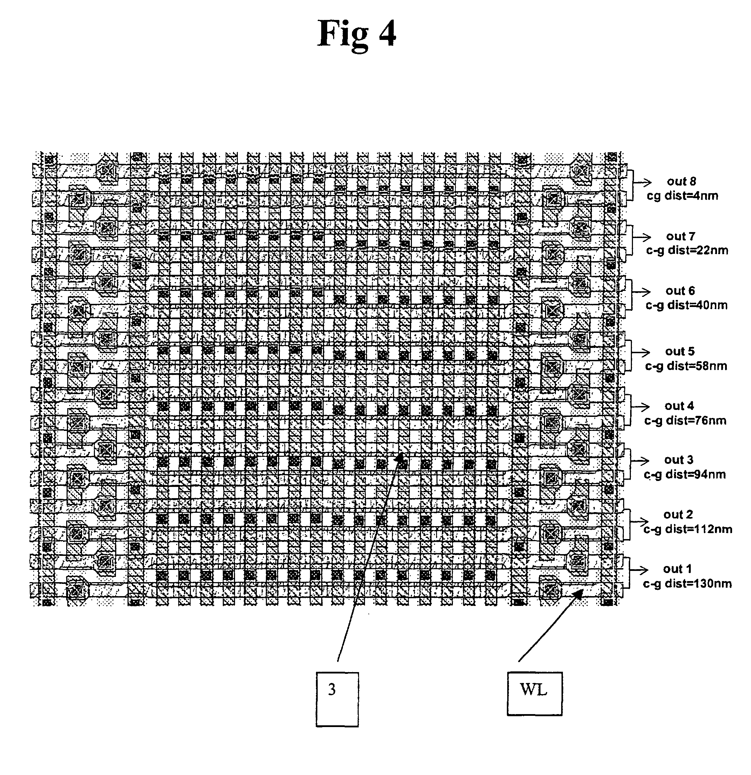

Referring to the drawing views, and particularly to Figures 3 and 4, a memory device architecture with a matrix of memory cell including rows and columns of non volatile memory cells is schematically shown at 1.

When using CMOS technologies, the rows of the flash cell matrices are formed in low-resistivity polysilicon. In technological processes providing for two or three metal levels, the polysilicon lines can be parallel connected to metal lines in order to reduce the overall parasitic resistance of the rows and, hence, the propagation delays, according to a technique known as wordline metal strapping.

In any case, the conductive layers providing the matrix rows have to be formed within the wordline pitch, that is, placed at submicron distances from one another. This feature of the architecture makes two rows being in physical contact with each other a statistically likely event apt to result in the creation of shorts at one or more spots.

With current integration technologies providing a high degree of control of the lithographic patterning, the spread of faults from the row conductive layers becomes restricted to isolated punctual regions of the matrix. Furthermore, faultiness is higher in the polysilicon lines than the metal-polysilicon lines.

According to the present invention, a test structure 2 is integrated into the memory device 1.

Advantageously, the test structure 2 is used for contact to gate distance evaluation during an EWS test.

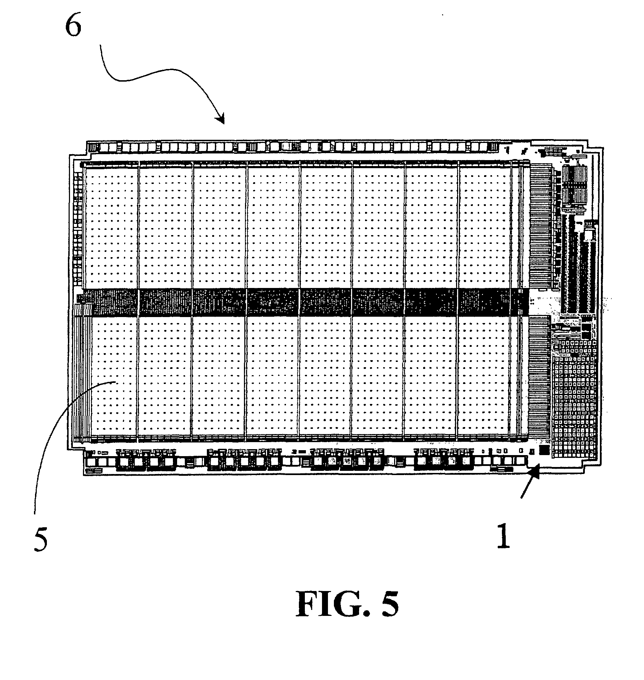

The test structure 2 comprises a small array of FLASH cells designed like the main memory matrix 5 inside the integrated memory device 6, as shown in Figure 5. This array of cells may be considered a second matrix 3 having a smaller size than the main matrix 5 of memory cells, even if the fact that this second matrix 3 has a smaller size than the main matrix 5 shall not be considered a limiting feature of this invention.

More particularly, the structure shown in Figure 3 as an example comprises an array of 12 rows x 16 columns with two source lines (Vss). Its size is approximately 17 µm x 15 µm.

This structure 2 can be easily inserted into any device layout, since its size is lower than the dimension of a single contact pad.

All bit lines BL and source lines SL of the matrix 3 may be connected to a common electrode. However, the second matrix 3 may work even if only the bit lines or the source lines are connected to a common reference potential.

Word lines WL are coupled and each couple differs from the neighbouring or adjacent ones for the distance to the corresponding contacts, which are designed with an appropriate misalignment toward the gate regions. So, each couple of word lines is characterized by an increasing contact-to-gate distance and this contact-to-gate distance is gradually variable from couple to couple.

The amount of misalignment is reported at one side of Figure 4 for each couple of word lines.

The same misalignment is applied to the drain contacts and/or to the source contacts in both up and down directions, in order to avoid random compensation due to process misalignment.

Each word line couple is connected to a different output line (in this example there are eight output lines, as shown in Figure 4: Out 1,Out 2, ..., Out 8)

According to this test structure, it's possible to implement a test method for evaluating the effective distance between contact to gate on the memory device.

Each word line output is tested separately, applying a potential bias with respect to common voltage reference, for instance the ground GND, and measuring the resulting current, which is the leakage of the selected gates.

As a convention, a test result can be classified as "1", if the measured current overcomes a defined limit Iref, otherwise as "0". The test results are included or joined into an eight-bit string, corresponding to the eight different word lines couples outputs.

For example, if the test of the structure shown in figure 4 gives a result 00000111, it means that all the word lines outputs with a 'nominal' contact to gate distance below 40 nm have a leakage higher than the defined Iref.

From this result it can be deduced that the misalignment between contact and gate of the device that contains this test structure is 40 nm and consequently its effective contact to gate distance on Silicon can be estimated as (nominal distance - 40 nm)

It must be pointed out that below a minimum dielectric thickness Th _{MIN} there is a leakage current through the dielectric. Considering the first leaky structure (output n) with contact to gate distance equal to D, its real contact to gate misalignment is D-Th _{MIN}.

Thus, in our example the real contact to gate distance can be calculated as: (nominal distance - 40nm + Th _{MIN})

Going on testing from Out 1 to Out 8 it can be reasonably supposed that all the outputs that follow the first leaky word line (the first "1") will drive current since they have a smaller contact to gate distance, so they will be classified as "1" too.

Consequently each device can be easily classified with a number N that is the sum of the eight bits of its output string. In a range between 1 and 8, this number N represents intrinsic reliability level of the dielectric between contact and gate. This number can be used to classify devices according to the write/erase cycling requirements of the application or to screen devices where contact to gate distance is lower than acceptable value.

The test structure and method according to the present invention solve the technical problem and achieve many advantages the most important of which is that of determining in advance a possible failure mode of the matrix of memory cells.

Moreover, as previously disclosed, according to the inventive test method it's possible to associate a numeric value N to the memory device, this value indicating the degree of reliability of the dielectric between the contact and the gate region. This evaluation was not possible according to prior art methods.

To summarise all the advantages:

The proposed structure allows monitoring with a large statistic one of the most critical technology parameter for FLASH reliability

The test structure has exactly the same layout as real FLASH array; moreover, the test structure can be easily inserted into any device layout, since its size is lower than the dimension of a single pad.

The test of the structure can be performed easily and rapidly during EWS1. Each device can be classified according to the write/erase cycling requirements of the application or to screen devices where contact to gate distance is lower than acceptable value.

The same test structure can be used to monitor similar problems for almost any kind of application.

Moreover, the inventive structure may be realized in a dual version, that is: connecting all the word lines to a common terminal and keeping separate bit lines. Each bit line is associated to a corresponding contact having a predetermined distance to the gates. The testing phase may be performed by applying a bias potential on a single bit line and detecting the flowing current.

The testing phase may proceed in this manner checking sequentially the other bit lines having different contact to gate distances.

The results of the testing phase may be treated in the same manner disclosed with reference to the contact to gate distance of the word lines.

## Claims

1. Integrated non-volatile memory device including a main matrix of cells organized into rows, or word lines, and columns, or bit lines, and including corresponding row and column decoding circuits as well as read, modify and erase circuits for reading and modifying data stored in the memory cells, **characterized by** comprising a test structure (2) including a second matrix (3) of cells comprising word line (WL) couples each having a different contact to gate distance witch respect to an adjacent word line couple.

2. Integrated memory device according to claim 1, wherein said second matrix has a smaller size than the main matrix of memory cells.

3. Integrated memory device according to claim 1, wherein the contacts are misaligned toward the corresponding word lines.

4. Integrated memory device according to claim 3, wherein a same misalignment is applied to drain and/or source contacts in both up and down directions.

5. Integrated memory device according to claim 1, wherein the contact-to-gate distance of the couples of word lines is gradually variable from couple to couple.

6. Integrated memory device according to claim 1, wherein said second matrix includes one or more bit lines that are connected to a common substrate reference.

7. Integrated memory device according to claim 1, wherein said second matrix includes one or more source lines that are connected to a common substrate reference.

8. Integrated memory device according to claim 1, wherein said second matrix has a whole size that is lower than the size of a single contact pad.

9. Integrated memory device according to claim 1, wherein each word line couple is connected to a different output line.

10. Integrated memory device according to claim 1, wherein said second matrix may be realized in a dual version connecting all the word lines to a common terminal and keeping separate bit lines; each bit line being associated to a corresponding contact having a predetermined distance to the gates.

11. Test method for measuring a contact to gate distance in a non-volatile memory device, said memory device including a main matrix of cells organized into rows, or word lines, and columns, or bit lines, and including corresponding row and column decoding circuits as well as read, modify and erase circuits for reading and modifying data stored in the memory cells, **characterized by** the following steps:
- providing a test structure (2) including a second matrix (3) of cells and comprising couples of word lines (WL) each having a different contact to gate distance with respect to an adjacent word line couple;
- applying a potential bias with respect to a common voltage reference and measuring the resulting current flowing in each couple of word lines;
- associating a logic value to the measured current when overcoming a predetermined limit (Iref).

12. Test method according to claim 11, **characterized by** the further step of
- joining in a bit string the logic values associated to the measured currents of said word lines to define a value corresponding to the different word lines couples outputs.

13. Test method according to claim 11, **characterized in that** said measured current value is indicative of the degree of reliability of the dielectric between the contact and the gate region.

14. Test method according to claim 11, **characterized in that** said measured current value allows to determine the effective contact to gate distance on Silicon.

## Patentansprüche

1. Integrierter, nichtflüchtiger Speicherbaustein, mit einer Hauptzellmatrix, die in Zeilen bzw. Wortleitungen, und Spalten bzw. Bitleitungen gegliedert ist, und entsprechenden Zeilen- und Spaltendecodierungsschaltungen sowie Lese-, Modifikations- und Löschungsschaltungen, um die in den Speicherzellen abgelegten Daten zu lesen und zu verändern, **dadurch gekennzeichnet, dass** er eine Prüfstruktur (2) umfasst, die eine zweite Zellmatrix (3) aufweist, welche Paare aus Wortleitungen (WL) umfasst, die hinsichtlich eines benachbarten Wortleitungspaares jeweils einen anderen Abstand von Kontakt zu Gate aufweisen.

2. Integrierter Speicherbaustein nach Anspruch 1, bei dem die zweite Matrix kleiner ausgelegt ist als die Hauptspeicherzellenmatrix.

3. Integrierter Speicherbaustein nach Anspruch 1, bei dem sich die Kontakte zu den entsprechenden Wortleitungen hin nicht in Ausrichtung befinden.

4. Integrierter Speicherbaustein nach Anspruch 3, bei dem dieselbe Fehlausrichtung bei Drain- und/oder Source-Kontakten sowohl in Aufwärts- als auch Abwärtsrichtung zur Anwendung kommt.

5. Integrierter Speicherbaustein nach Anspruch 1, bei dem der Abstand von Kontakt zu Gate der Wortleitungspaare graduell von Paar zu Paar veränderlich ist.

6. Integrierter Speicherbaustein nach Anspruch 1, bei dem die zweite Matrix eine oder mehrere Bitleitungen umfasst, welche mit einem gemeinsamen Grundsubstrat verbunden sind.

7. Integrierter Speicherbaustein nach Anspruch 1, bei dem die zweite Matrix eine oder mehrere Source-Leitungen umfasst, welche mit einem gemeinsamen Grundsubstrat verbunden sind.

8. Integrierter Speicherbaustein nach Anspruch 1, bei dem die zweite Matrix eine Gesamtgröße aufweist, die kleiner ist als ein einzelner Kontaktfleck.

9. Integrierter Speicherbaustein nach Anspruch 1, bei dem jedes Wortleitungspaar an eine andere Ausgangsleitung angeschlossen ist.

10. Integrierter Speicherbaustein nach Anspruch 1, bei dem die zweite Matrix in doppelter Version ausgeführt sein kann, bei welcher alle Wortleitungen mit einem gemeinsamen Anschluss verbunden sind und die separate Bitleitungen unterhält; wobei jede Bitleitung einem entsprechenden Kontakt zugeordnet ist, der einen vorgegebenen Abstand zu den Gates hat.

11. Prüfverfahren zur Messung eines Abstands von Kontakt zu Gate in einem nichtflüchtigen Speicherbaustein, wobei der Speicherbaustein eine Hauptzellmatrix umfasst, die in Zeilen bzw. Wortleitungen, und Spalten bzw. Bitleitungen gegliedert ist, und entsprechende Zeilen- und Spaltendecodierungsschaltungen sowie Lese-, Modifikations- und Löschungsschaltungen, um die in den Speicherzellen abgelegten Daten zu lesen und zu verändern, **gekennzeichnet durch** die folgenden Schritte:
- Bereitstellen einer Prüfstruktur (2), die eine zweite Zellmatrix (3) beinhaltet und Paare aus Wortleitungen (WL) umfasst, die hinsichtlich eines benachbarten Wortleitungspaares jeweils einen anderen Abstand von Kontakt zu Gate aufweisen;
- Anlegen einer Potentialvorspannung im Hinblick auf eine gemeinsame Spannungsreferenz und Messen des sich ergebenden Stroms, der in jedem Wortleitungspaar fließt;
- Zuordnen eines logischen Wertes zum gemessenen Strom, sobald dieser einen vorher bestimmten Grenzwert übersteigt (Iref).

12. Prüfverfahren nach Anspruch 11, durch folgenden weiteren Schritt **gekennzeichnet**:
- Zusammenfassung der logischen Werte, welche den gemessenen Strömen der Wortleitungen zugeordnet sind, zu einer Bitfolge, um einen Wert zu bestimmen, der den verschiedenen Ausgängen der Wortleitungspaare entspricht.

13. Prüfverfahren nach Anspruch 11, **dadurch gekennzeichnet, dass** der gemessene Stromwert den Grad der Zuverlässigkeit des Dielektrikums zwischen dem Kontakt und dem Gate-Bereich anzeigt.

14. Prüfverfahren nach Anspruch 11, **dadurch gekennzeichnet, dass** mit dem gemessenen Stromwert der tatsächliche Abstand von Kontakt zu Gate auf Silizium bestimmt werden kann.

## Revendications

1. Dispositif de mémoire non volatile intégré comprenant une matrice principale de cellules organisées en lignes, ou lignes de texte, et en colonnes, ou lignes binaires, et comprenant des circuits de décodage de lignes et de colonnes correspondants ainsi que des circuits de lecture, modification et effacement pour lire et modifier les données mémorisées dans les cellules de mémoire, **caractérisé en ce qu'**il comprend une structure de test (2) comprenant une deuxième matrice (3) de cellules comprenant des couples de lignes de texte (WL) présentant chacun une distance de connexion à grille différente par rapport à un couple de lignes de texte adjacent.

2. Dispositif de mémoire intégré selon la revendication 1, dans lequel ladite deuxième matrice présente une taille inférieure à la matrice principale des cellules de mémoire.

3. Dispositif de mémoire intégré selon la revendication 1, dans lequel les connexions présentent un défaut d'alignement envers les lignes de texte correspondantes.

4. Dispositif de mémoire intégré selon la revendication 3, dans lequel un défaut d'alignement identique est appliqué aux connexions de drain et/ou de source dans les deux directions montantes et descendantes.

5. Dispositif de mémoire intégré selon la revendication 1, dans lequel la distance de connexion à grille des couples de lignes de texte varie de manière progressive d'un couple à l'autre.

6. Dispositif de mémoire intégré selon la revendication 1, dans lequel ladite deuxième matrice comprend une ou plusieurs lignes binaires qui sont connectées à une référence de substrat commune.

7. Dispositif de mémoire intégré selon la revendication 1, dans lequel ladite deuxième matrice comprend une ou plusieurs lignes de source qui sont connectées à une référence de substrat commune.

8. Dispositif de mémoire intégré selon la revendication 1, dans lequel ladite deuxième matrice présente une taille globale qui est inférieure à la taille d'un plot de connexion unique.

9. Dispositif de mémoire intégré selon la revendication 1, dans lequel chaque couple de lignes de texte est connecté à une ligne de sortie différente.

10. Dispositif de mémoire intégré selon la revendication 1, dans lequel ladite deuxième matrice peut être réalisée en une version double qui connecte toutes les lignes de texte à un terminal commun et qui garde les lignes binaires séparées ; chaque ligne binaire étant associée à une connexion correspondante présentant une distance prédéterminée aux grilles.

11. Procédé de test pour mesurer une distance de connexion à grille dans un dispositif de mémoire non volatile, ledit dispositif de mémoire comprenant une matrice principale de cellules organisées en lignes, ou lignes de texte, et en colonnes, ou lignes binaires, et comprenant des circuits de décodage de lignes et de colonnes correspondants ainsi que des circuits de lecture, modification et effacement pour lire et modifier les données mémorisées dans les cellules de mémoire, **caractérisé par** les étapes consistant à :
• fournir une structure de test (2) comprenant une deuxième matrice (3) de cellules et comprenant des couples de lignes de texte (WL) présentant chacun une distance de connexion à quille différente par rapport à un couple de lignes de texte adjacent ;
• appliquer une polarisation en tension par rapport à une référence de tension commune et mesurer le courant résultant circulant dans chaque couple de lignes de texte ;
• associer une valeur logique au courant mesuré lors d'un dépassement d'une limite prédéterminée (Iref).

12. Procédé de test selon la revendication 11, **caractérisée par** l'étape supplémentaire consistant à :
• joindre les valeurs logiques associées aux courants mesurés desdites lignes de texte à une chaîne de bits afin de définir une valeur correspondant aux différentes sorties de couples de lignes de texte.

13. Procédé de test selon la revendication 11, **caractérisée en ce que** ladite valeur de courant mesuré indique le degré de fiabilité du diélectrique entre la connexion et la région de grille.

14. Procédé de test selon la revendication 11, **caractérisée en ce que** ladite valeur de courant mesuré permet de déterminer la distance de connexion à grille réelle sur du silicium.
